# EUROPEAN PATENT APPLICATION

(11) **EP 2 528 101 A2**
(43) Date of publication of application: **28.11.2012**
(21) Application number: 12181001.4
(22) Date of filing: 21.09.2007
(51) Int. Cl.: H01L 31/0224, H01L 31/04, H01L 51/42, H01L 31/18, H01L 51/48, H01G 9/20

(54) **Dye sensitized solar cell**

(30) Priority: 10.11.2006 CN 200610114454
(62) Divisional of application: 07816412.6
(71) Applicant: Peking University, Beijing 100871 (CN)
(72) Inventor: Zou, Dechun, 100871 Beijing (CN); Fan, Xing, 100871 Beijing (CN); Jian, Rong, 100871 Beijing (CN)
(74) Representative: HOFFMANN EITLE

(57) **Abstract**

A dye sensitized solar cell is provided comprising a working electrode, an electrolyte layer and a counter electrode. The working electrode is composed of a filamentous conductive substrate and a sensitized semiconductor film, wherein the sensitized semiconductor film is a porous film structure composed of semiconductor particles of different sizes absorbed with sensitizing dye molecules. The sensitized semiconductor film is coated on the outer surface of the filamentous conductive substrate. The working electrode is joined with the counter electrode by entwisting or attachment. The electrolyte fills in the interspace between the working electrode and the counter electrode.

## Description

### Technical Field

The present invention relates to the field of solar cell technology, and particularly, to a dye sensitized solar cell's construction and a working electrode thereof.

### Background Art

A dye sensitized solar cell comprises mainly of a working electrode, an electrolyte layer and a counter electrode, in which the electrolyte layer can be solid or liquid as well. The working electrode comprises a conductive substrate, a porous film of semi-conductor material and dye molecules for sensitizing. Limited by the material and processing technology of conventional solar cells, normally the conductive substrate of the working electrode is planar structured. When assembling a solar module, it is only possible to connect from single cells by additional wires. In many circumstances, especially the portable electronic devices that are developing fast nowadays, the available space is very limited and of irregular shape, and even varies as the application situation changes (such as highly integrated intelligent garments, outer decorations, etc.). The planar structure of conventional solar cells confines their own applicable range enormously, and constrains the ideation of designers. In addition, in the power supply of a real electronic circuit, higher driving voltage (> 3V) is often required, but it is not necessary for the current to be high, therefore a solar module formed by a plurality of cells in a manner of series connection and the like is required for supplying power. The conventional connection approach with additional wires makes the already narrow space inside a microelectronic element even more deficient.

In addition, the main bottleneck that limits a large scale application of dye sensitized solar cells lies in the cost. Due to the limitation by process, usually the high manufacturing cost of conventional planar photovoltaic cells with special shapes can hardly be accepted in the civil grade commercialized application.

### Summary of the Invention

Aiming at the problems and disadvantages of the existing solar cells, an object of the present invention is to provide a solar cell which is freely deformable, accessible for series-parallel connection, low in cost, and is specifically suitable for narrow and irregular-shaped space requiring specific driving power supply.

The above object of the present invention is achieved by the following technical solutions:
a working electrode of a dye sensitized solar cell, comprising a filamentous conductive substrate and a sensitized semi-conductor film, wherein the sensitized semi-conductor film is a porous film structure composed of semi-conductor particles of different sizes absorbed with sensitizing dye molecules, and the sensitized semi-conductor film is coated on the outer surface of the filamentous conductive substrate.

The filamentous conductive substrate can be a solid or hollow structure made of a conductive material, and can also comprise a core and several layers of sheath. The core is of a conductive or nonconductive material. The sheaths surround outside the core layer by layer, and the outermost layer of sheath is of a conductive material. The conductive material is an organic conductive material or an inorganic conductive material or an organic/inorganic composite conductive material.

The filamentous conductive substrate can be formed not only by one filament, but also by two or more filaments collectively in a manner of intimately arranging, wrapping around each other, twisting with each other and the like.

The surface of the filamentous conductive substrate can be further coated by a layer of compact semi-conductor or insulator material.

The sensitized semi-conductor film coated on the filamentous conductive substrate may be 1 micron to 100 microns in thickness.

A dye sensitized solar cell comprises a working electrode, an electrolyte layer and a counter electrode. The working electrode is made up of a filamentous conductive substrate and a sensitized semi-conductor film, wherein the sensitized semi-conductor film is a porous film structure composed of semi-conductor particles of different sizes absorbed with sensitizing dye molecules, and the sensitized semi-conductor film is coated on the outer surface of the filamentous conductive substrate. The electrolyte fills in the interspace between the working electrode and the counter electrode.

The electrolyte layer can be a liquid electrolyte, a solid inorganic or organic semi-conductor, an ionic liquid, an inorganic or organic gel electrolyte or a solid inorganic conductor based on fast-transfer ions.

The counter electrode can be a conductor of any shape, such as filamentous, planar or blocky, or it can also consist of conductors with one or more of the three shapes mentioned above collectively in a way of intimately arranging, entwisting with each other and the like. The counter electrode can be a solid or hollow structure made of a conductive material, and it can also include a core and several layers of sheath, where the core is a conductive or nonconductive material with the sheaths covering outside layer by layer, and the outermost layer is of a conductive material. The conductive material is an organic conductive material or inorganic conductive material or organic/inorganic composite conductive material. The external surface of the counter electrode can be a continuous or noncontinuous, compact or porous surface having flexure or bending of any curvature.

The surface of the counter electrode may be further coated with a layer of catalyst which can be 1 nm to 1000 nm in thickness.

The working electrode is joined with the counter electrode in a manner of entwisting, intimately juxtaposition or attachment and the like. The interstice between the working electrode and the counter electrode is in a range of 0.001 mm to 1 cm.

### Technical Effect of the Present Invention

The present invention is a dye sensitized solar cell in which its working electrode utilizes filamentous conductive substrate structure. Its advantages include source abundance, small volume, easiness of deformation, processing convenience and accessibility for series-parallel connection. The present invention provides a cheap and highly efficient solution for solar energy power supply in a narrow and irregular-shaped space.

### Brief Description of the Drawings

The present invention will be described in details below with reference to the drawings.
Figure 1 is an axial sectional structural schematic diagram of a filamentous working electrode of a dye sensitized solar cell in embodiment 1 of the present invention;
Figure 2 is a radial sectional structural schematic diagram of a filamentous working electrode of a dye sensitized solar cell in embodiment 1 of the present invention;
Figure 3 is a side structural schematic diagram of a dye sensitized solar cell used in embodiment 1 of the present invention;
Figure 4 is a sectional structural schematic diagram taken along A-A in Figure 3;

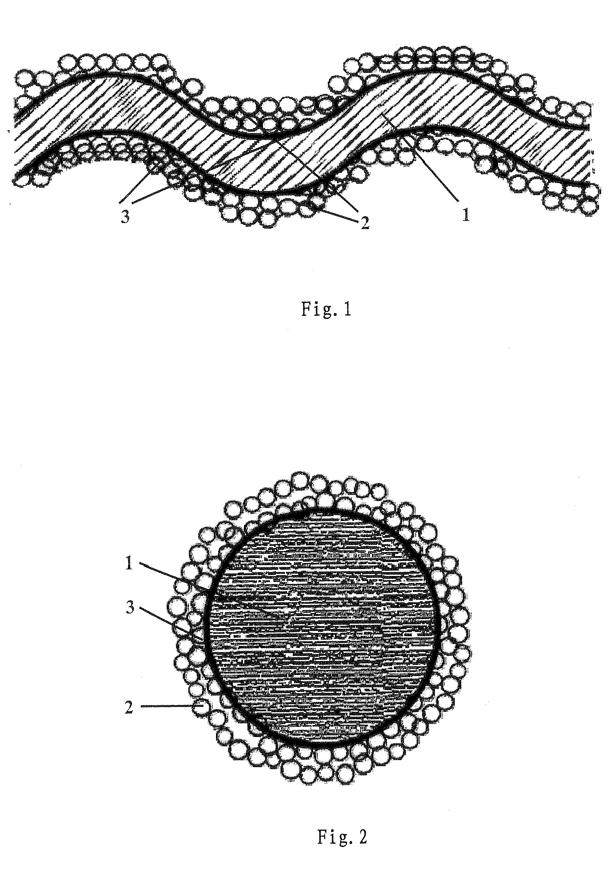

In Figures 1-4: 1-filamentous conductive substrate, 2-sensitized semi-conductor film, 3-compact layer, 4-counter electrode, 5-electrolyte, 6-filamentous working electrode.

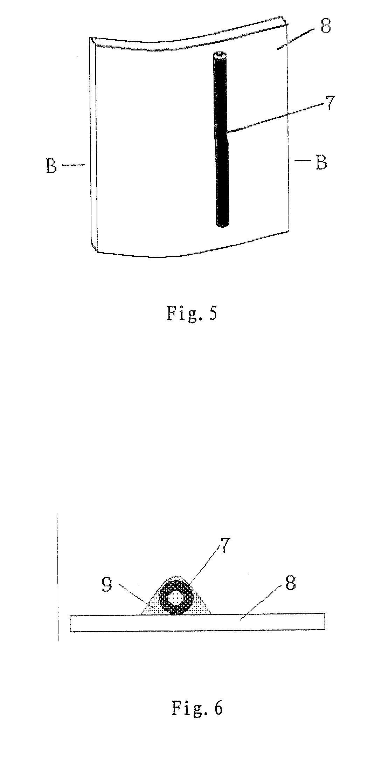

Figure 5 is a top view structural schematic diagram of the dye sensitized solar cell used in embodiment 2 of the present invention;

Figure 6 is a structural schematic diagram of the surface section taken along B-B in Figure 5;

In Figure 5 and Figure 6: 7-filamentous working electrode, 8-counter electrode, 9-electrolyte.

### Preferred embodiments of the Invention

### Embodiment 1

As shown in Figure 1 and Figure 2, the working electrode of the dye sensitized solar cell comprises a filamentous conductive substrate 1 and a sensitized semi-conductor film. 2, wherein the sensitized semi-conductor film 2 is a porous film structure composed of semi-conductor particles of different sizes absorbed with sensitizing dye molecules, and the sensitized semi-conductor film 2 is coated on the outer surface of the filamentous conductive substrate 1.

The sensitized semi-conductor film of the working electrode in the dye sensitized solar cell is prepared according to the following procedure: a semi-conductor material is spray coated and sintered several times on the filamentous conductive substrate, and the filamentous conductive substrate with the sintered semi-conductor material is placed in a dye for sensitization.

The semi-conductor material is any semi-conductor material suitable for the working electrode of the dye sensitized solar cell, most typically nanoscale TiO₂, ZnO and the like. The size and distribution of the nano particles are the same as those of the nano particles used for general dye sensitized solar cells. The application process thereof can follow conventional methods, such as spray coating, print coating, immersion coating, dip coating, doctor blade coating and the like.

All of the dyes suitable for conventional dye sensitized solar cells are also suitable for sensitizing the semi-conductor material of the present working electrode, and completely identical sensitizing methods can be applied.

The sensitized semi-conductor film 2 coated on the filamentous conductive substrate 1 can be 1 micron to 100 microns in thickness.

In order to ensure good flexibility while ensuring enough mechanical strength and conductivity, the diameter of the filamentous conductive substrate 1 does not exceed 1 mm in general, and its apparent resistivity is < 100 ohm cm⁻¹.

The filamentous conductive substrate 1 may have a filamentous structure made of metal filaments such as stainless steel filaments, alloy filaments and the like, or nonmetal conductive filaments such as carbon fibers, conductive polymers, inorganic conductive compound fibers and organic/inorganic composite conductive fibers or the like. A conductive material sheath can also be applied on the outer surface of the filamentous core made from conductive or nonconductive materials, or the filamentous conductive substrate 1 can also be made by coating a conductive material outside a gas medium or a vacuum medium.

The filamentous conductive substrate can be formed not only by one filament, but also by two or more filaments collectively in a way of intimately arranging, wrapping around each other, twisting with each other, and the like.

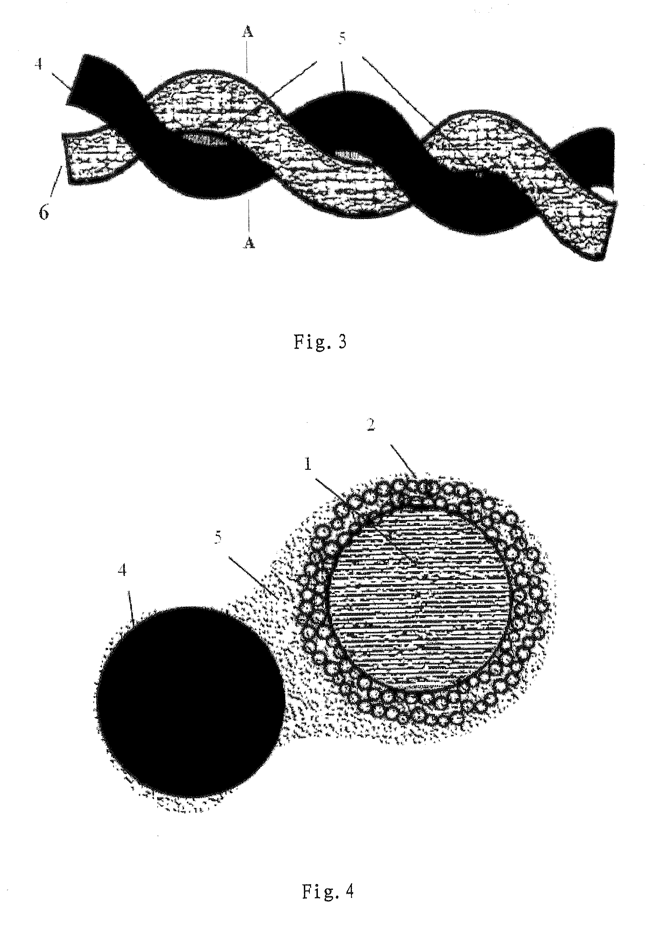

With reference to Figure 3 and Figure 4, a stainless steel filament approximately 100 microns in diameter is used as the filamentous conductive substrate 1 of the working electrode; and a Pt filament approximately 100 microns in diameter is used as the counter electrode 4. The effective length of the cell prepared is 5 cm². The detailed preparation procedure for the working electrode is as follows:

First, the prepared stainless steel filament is washed with an organic solvent, such as acetone etc., and then washed with a substrate cleanser. Thereafter, the stainless steel filament is incandesced at 400°C-500°C for 15 minutes, and naturally cooled at room temperature. Under the roast of an infrared lamp, the incandesced stainless steel filament is spray coated with a solution of tetraethyl titanate/acetylacetone in ethanol, and then sintered again at 500°C for 30 minutes, and naturally cooled, thus a compact layer of semi-conductor material TiO₂ about 0.9 micron in thickness on the stainless steel filament is obtained. The semi-conductor material TiO₂ emulsion normally used in dye sensitized solar cells is spray coated on the compact layer, and then sintered at 500 °C for 30 minutes. After the above spray coating and sintering processes are repeated twice, the overall thickness of the semi-conductor material TiO₂ layer on the stainless steel filament reaches 4-9 microns. After the sintered working electrode 6 comprising semi-conductor material TiO₂ is appropriately wrapped with the Pt filament counter electrode 5, it is placed in N3 dye/ethanol solution at a concentration of 3 × 10⁻⁴ mole/L for 12 hours or more, and then removed from the solution and air dried. The sensitized semi-conductor film 2 is coated on the surface of the filamentous conductive substrate 1.

In order to improve the conductivity, activity and stability of the working electrode, as well as the charge transfer from the semi-conductor to the filamentous conductive substrate, the interfacial adhesion characteristic and the like, it may be considered to physically or chemically modify the surface of the filament-structured filamentous conductive substrate 1, such as surface treatment, surface coating, etc.; for example, in order to improve the cell property, a compact layer 3 made of a semi-conductor or insulating material can further be coated on the surface of the filamentous conductive substrate 1 to prevent the electrolyte 5 from directly contacting with the filamentous conductive substrate 1.

The methods for preparing the compact layer are sputtering, vacuum thermal evaporation plating, spray coating, and electrochemistry method.

After soaked in a standard electrolyte of normal liquid dye sensitized solar cells for 5 seconds, the electrolyte 5 is filled in the interspace between the filamentous working electrode 6 and the counter electrode 4, thus the dye sensitized solar cell of the present invention is produced.

The cell property is measured under the condition of AM 1.5 (ASTM E892) and one time sun light intensity. The results obtained are: cell open circuit voltage is 580 mV, the short circuit current per centimeter length is 0.025 mA, and the overall photoelectric conversion efficiency is 0.91 %.

The counter electrode can be a solid or hollow structure made of conductive materials, or it can consist of a core and several layers of sheath. The core and the sheath can be made from conductive or nonconductive materials, while the outermost layer of sheath coated is made of conductive materials. The conductive material used in the counter electrode 4 can be organic conductive material, inorganic conductive material (including metallic material) or organic/inorganic composite conductive material.

In order to improve the electrochemical activity of the counter electrode 4 while decreasing its cost, a highly efficient catalyst layer can be added on the surface of the counter electrode 4, such as plating Pt on the stainless steel filament surface.

The external surface of the counter electrode 4 can be a continuous or noncontinuous, compact or porous surface having a flexure or bending of any curvature. The filamentous working electrode 6 can be arranged with the outer surface of the counter electrode 4 by wrapping, intimately juxtaposition or attaching. The distance between the filamentous working electrode 6 and the outer surface of the counter electrode 4 is in a range of 0.001 mm to 1 cm.

### Embodiment 2

As shown in Figure 5 and Figure 6, the preparation method for the filamentous working electrode 7 of the dye sensitized solar cell is the same as that for the filamentous working electrode 6 described in embodiment 1 of the present invention. Here, the filamentous conductive substrate of the filamentous working electrode 7 utilizes carbon fibers with a diameter of 5 microns.

The counter electrode 8 is a flexible planar conductor. The filamentous working electrode 7 can be arranged with the outer surface of the counter electrode 8 by intimately juxtaposition or attaching, and the interstice there between is filled with electrolyte 9. The electrolyte 9 can be any standard electrolyte system normally used in the preparation of dye sensitized solar cells. In the present embodiment, solid CuI electrolyte is used.

The cell property is measured under the condition of AM 1.5 (ASTM E892) and one time sun light intensity. The results obtained are: cell open circuit voltage is 500 mV, the short circuit current per centimeter length reaches 0.030 mA, and the overall photoelectric conversion efficiency is 3%.

To sum up, the present invention discloses a working electrode of a dye sensitized solar cell and a dye sensitized solar cell structure based on it. The application conditions and examples described above are not for the purpose of limiting the present invention. Any skilled in the art can make various change and modification without departing from the spirit and scope of the present invention, therefore the range of protection of the present invention is defined by the scope of the claims.

## Claims

1. A dye sensitized solar cell comprising a working electrode, an electrolyte layer and a counter electrode, **characterized in that** the working electrode is composed of a filamentous conductive substrate and a sensitized semiconductor film, wherein the sensitized semiconductor film is a porous film structure composed of semiconductor particles of different sizes absorbed with sensitizing dye molecules, and the sensitized semiconductor film is coated on the outer surface of the filamentous conductive substrate, the working electrode being joined with the counter electrode by entwisting or attachment, and the electrolyte fills in the interspace between the working electrode and the counter electrode.

2. A cell according to Claim 1, **characterized in that** the counter electrode is made of a conductive material, and it is a solid structure or hollow structure.

3. A cell according to Claim 1, **characterized in that** the counter electrode comprises a core and several layers of sheaths, wherein the core is a conductive material or nonconductive material, and the sheaths surround outside the core layer by layer, and the outermost layer of sheath is a conductive material.

4. A cell according to Claim 2 or Claim 3, **characterized in that** the conductive material is an organic conductive material, an inorganic conductive material or an organic/inorganic composite conductive material.

5. A cell according to any of Claims 1-3, **characterized in that** the surface of the counter electrode is coated with a catalyst layer having a thickness in the range of 1 nm to 1000 nm.

6. A cell according to any of Claims 1-3, **characterized in that** the interstice between the working electrode and the counter electrode is in the range of 0.001 mm to 1 cm.
